Europäisches Patentamt

European Patent Office

Office européen des brevets

(11) Publication number: **0 071 306**
A1

# (12) EUROPEAN PATENT APPLICATION

(21) Application number: 82200924.7

(22) Date of filing: 20.07.82

(51) Int. Cl.³: **H 01 F 17/04**
H 01 F 5/04, H 01 F 5/00

(30) Priority: 30.07.81 NL 8103602

(43) Date of publication of application:
09.02.83 Bulletin 83/6

(84) Designated Contracting States:
DE FR GB IT NL

(71) Applicant: N.V. Philips' Gloeilampenfabrieken
Groenewoudseweg 1
NL-5621 BA Eindhoven(NL)

(72) Inventor: Smeets, Frans Hubert Mathys
c/o INT. OCTROOIBUREAU B.V. Prof.Holstlaan 6
NL-5656 AA Eindhoven(NL)

(74) Representative: Veenstra, Gustaaf et al,
INTERNATIONAAL OCTROOIBUREAU B.V. Prof.
Holstlaan 6
NL-5656 AA Eindhoven(NL)

(54) Electric coil.

(57) The coil comprises a coil base with a rod-shaped central portion (1) and two end portions (3, 5) wherebetween a winding (15) made from a conductor (13) is situated. The entire coil is situated within an imaginary parallelepiped comprising six boundary faces, a first and a second boundary surface enclosing angles with the axis (11) of the central portion which are the complement of one another. The first and second boundary faces each contain an outer surface (21, 23) of the first end portion (3) on which contact surfaces (25, 27) are situated, each of which is conductively connected to an anchor point (17) for the conductor (13). A third and a fourth boundary face which are parallel to the first and the second boundary face, respectively, each contain an outer surface (31, 33) of the second end portion (5). The coil can be very simply mounted as desired with its axis (11) perpendicular to a substrate (29) or parallel to the substrate, so that two identical coils can be mounted on a substrate with mutually perpendicular axes, with the result that they are not or only slightly coupled to one another.

FIG.1

"Electric coil".

The invention relates to an electric coil with a coil base which comprises a rod-shaped central portion and at each extremity an end portion which comprises an inner surface which faces the central portion and which extends approximately perpendicularly to the axis of the central portion, between said inner surfaces there being provided a winding which consists of an electric conductor whose ends are anchored at anchor points on the first one of the two end portions.

The end portions of known coils of this kind (for example, see German Offenlegungsschrift 1,815,479) are shaped as discs which extend perpendicularly to the axis of the central portion and which comprise protrusions with anchor points. These coils are intended for mounting on a flat substrate, for example, a printed circuit board or a hybrid circuit. The position of the coil with respect to the substrate is determined by the location of the protrusions. Said Offenlegungsschrift describes two types of coil: one coil which must be mounted so that the axis of the rod-shaped central portion extends perpendicularly to the plane of the substrate, and one coil which must be mounted so that said axis extends parallel to the plane of the substrate.

When two coils of the same type are mounted in the vicinity of one another, the axis of their central portions will usually be mutually parallel, so that the coils exhibit a comparatively large mutual magnetic coupling. Such coupling in many cases has an adverse effect on the operation of the circuit in which the coils are incorporated. The coupling is substantially smaller when the axes of the two coils extend at right angles. Obviously, this can be achieved by mounting two coils of a different type one adjacent the other. The number of different coils in a circuit is thus increased, which has a cost increasing effect. Moreover, the two types of known coils are not very suitable for positioning on a substrate by means of the same automatic mounting tool.

Another possibility of reducing the coupling between two neighbouring coils to substantially zero is to mount two coils of the type whose axis extends parallel to the substrate so that the one coil is rotated through 90° about its vertical axis with respect to the other coil. However, this also involves complications as regards the automatic mounting tool and, moreover, the freedom of the designer as regards the choice of the paths of the conductor tracks and the situation of the solder pads on the substrate is substantially limited.

The invention has for its object to provide a coil of the kind set forth which can be mounted so that its axis extends perpendicularly to the substrate or parallel to the substrate without giving rise to additional problems, with the result that the advantages of both said methods for the uncoupling of coils are combined without their drawbacks.

To this end, the coil in accordance with the invention is characterized in that no part of the coil projects outside an imaginary parallelepiped having six boundary faces, a first and a second boundary face thereof enclosing angles with respect to the axis of the central portion which are the complement of one another, said first and second boundary face each containing an outer surface of the first end portion on which there are situated contact surfaces, each of which is conductively connected to one of the anchor points, a third and a fourth boundary face which extend parallel to the first and the second boundary face, respectively, containing an outer surface of the second end portion, each.

Two of such coils can be arranged so that their axes extend perpendicularly to one another by tilting one of the coils through 90° about its horizontal axis.

Mounting can in both cases be realized by means of the same tool and the positions of the conductor tracks and the solder pads are not dependent on the position of the axis of the coil.

The invention will be described in detail hereinafter with reference to the drawing. Therein:

Figure 1 is a perspective front view of an embodiment of a coil in accordance with the invention, whose axis extends parallel to the substrate, and

Figure 2 is a side elevation of the coil shown in Figure 1, its axis now extending perpendicularly to the substrate.

The coil shown comprises a coil base with a rod-shaped central portion 1 (denoted by broken lines), an end portion 3, 5 being present at each extremity thereof. Each of the end portions 3, 5 has an inner surface 7,9, respectively, which faces the central portion 1 and which extends perpendicularly to the axis 11 (stroke-dot line) of the central portion. The coil base may be completely made of ferrite or a non-ferromagnetic substance such as a plastics.

Between the inner surfaces 7, 9 there is arranged a winding 15 which is made of an electric conductor 13 and whose ends are anchored to anchor points 17 on the first end portion 3. The anchor points 17 are formed by metallized surfaces whereto the conductor 13 is electrically and mechanically connected, for example, by way of soldered connections 19.

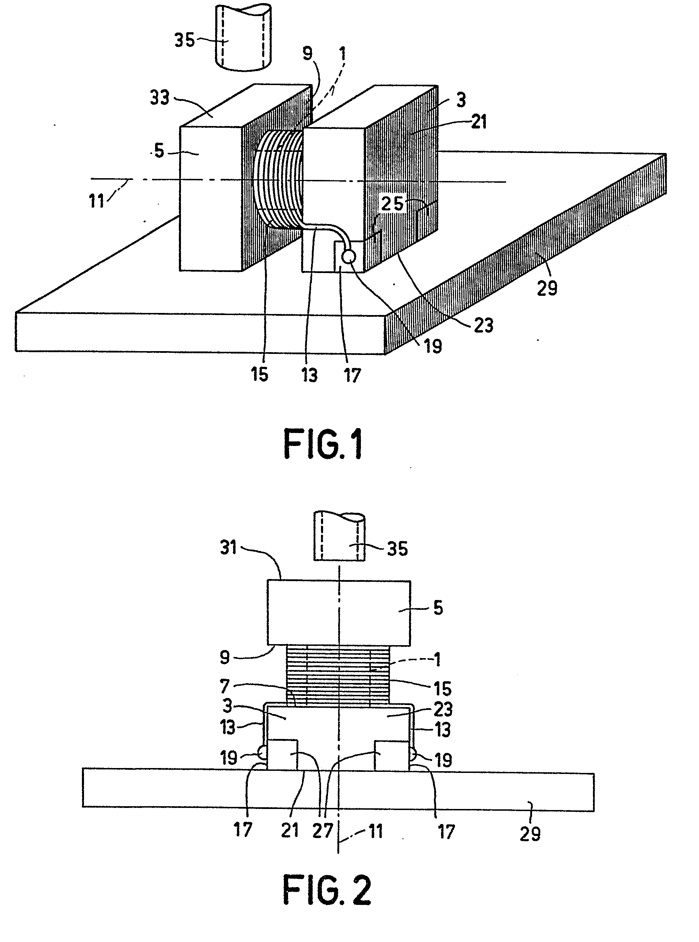

The entire coil is situated within the six boundary faces of an imaginary parallelepiped. The first and the second boundary face enclose angles with respect to the axis 11 of the central portion 1 which are the complement of one another, so that these boundary faces extend perpendicularly to one another. The first boundary face contains an outer surface of the first end portion 3 which extends perpendicularly to the axis 11, i.e. the right outer surface 21 which faces downwards in Figure 1. The second boundary face contains an outer surface of the first end portion 3 which is parallel to the axis 11, i.e. the downward facing surface 23 in Figure 1 which is situated in the plane of the drawing in Figure 2.

On the outer surfaces 21, 23 of the first end portion 3 which are situated in the first and the second boundary face, respectively, there are situated contact surfaces 25, 27, respectively, each of which is conductively connected to one of the anchor points 17. These contact surfaces are metallized surfaces formed to be integral with the anchor points. Via the contact surfaces 25 or 27, the coil is electrically connected to conductor tracks (not shown) on a substrate 29, for example, a printed circuit board or a hybrid circuit. The connection between the contact surfaces 25, 27 and the conductor tracks may be a soldered connection or a glued connection. The axis 11 of the central portion 1 in Figure 1 is parallel to the upper surface of the substrate 29 and the contact surfaces 27 are connected to the conductor tracks on this substrate. The axis 11 in Figure 2 extends perpendicularly to the upper surface of the substrate 29 and the contact surfaces 25 are connected to the conductor tracks. Evidently, it is merely necessary to rotate the coil through 90° about a horizontal axis for mounting in the one way or the other. If two of these coils are adjacently mounted, one coil being mounted in accordance with Figure 1 and the other coil in accordance with Figure 2, there axes 11 extend perpendicularly to one another and the coils are not coupled or are coupled only slightly.

In order to facilitate the handling of the coil for mounting by means of automatic equipment, opposite the outer surfaces 21, 23 with contact faces 25, 27 of the first end portion 3 there are situated outer surfaces 31, 33 of the second end portion which are situated in a third and a fourth boundary face, respectively, of the parallelepiped. The third boundary face extends parallel to the first boundary face and the fourth boundary face is parallel to the second boundary face. Consequently, the outer surfaces 31, 33 are excellently suitable for cooperation with a vacuum pipette 35 which forms part of a mounting apparatus.

The first boundary face extends perpendicularly to the axis 11 of the central portion 1 in the described

**0071306**

embodiment, and the second boundary face is parallel to said axis. Other angles between these boundary faces and the axis 11 are also feasible, provided that the angles between the axis and the two boundary faces are the complement of one another.

The anchor points 17 need not consist of metallized surfaces whereto the conductor 13 is connected by means of soldered connections 19. For example, it is alternatively possible to provide the outer surfaces of the first end portion 3, directed to the left and to the right in Figure 2, with protrusions around which the conductor 13 is wrapped.

An electric coil with a coil base which comprises a rod-shaped central portion (1) and at each extremity an end portion (3, 5) which comprises an inner surface (7, 9) which faces the central portion and which extends substantially perpendicularly to the axis (11) of the central portion, between said inner surfaces there being provided a winding (15) which consists of an electric conductor (13) whose ends are anchored to anchor points (17) on the first one of the two end portions (3), characterized in that no part of the coil projects outside an imaginary parallelepiped having six boundary faces, a first and a second boundary face thereof enclosing angles with respect to the axis (11) of the central portion (1) which are the complement of one another, said first and second boundary face each containing an outer surface (21, 23) of the first end portion (3) on which there are situated contact surfaces (25, 27), each of which is conductively connected to one of the anchor points (17), a third and a fourth boundary face which extend parallel to the first and the second boundary face, respectively, containing an outer surface (31, 33) of the second end portion (5) each.

FIG.1

FIG.2

# EUROPEAN SEARCH REPORT

European Patent Office

EP 82 20 0924

## DOCUMENTS CONSIDERED TO BE RELEVANT

| Category | Citation of document with indication where appropriate, of relevant passages | Relevant to claim | CLASSIFICATION OF THE APPLICATION (Int. Cl. ³) |
|---|---|---|---|
| | --- | | H 01 F 17/04 |
| X | US-A-3 585 553 (W.L.MUCKELROY et al.) *Column 2, lines 11-38* | 1 | H 01 F 5/04 H 01 F 5/00 |
| | --- | | |
| Y | US-A-3 593 217 (TEXAS INSTRUMENTS INC.) *Column 3, lines 31-71* | 1 | |
| | --- | | |
| Y | US-A-3 001 106 (MOORE, HALL, POLLOCK) *Column 5, lines 72-75; column 6, lines 1-10* | 1 | |
| | --- | | |
| A | US-A-4 064 472 (VANGUARD ELECTRONICS COMPANY) *Column 3, lines 7-11* | 1 | |
| | ----- | | TECHNICAL FIELDS SEARCHED (Int Cl ³) |
| | | | H 01 F 17/00 H 01 F 5/00 H 01 F 3/00 H 01 F 27/00 |

The present search report has been drawn up for all claims

| Place of search | Date of completion of the search | Examiner |
|---|---|---|
| THE HAGUE | 03-11-1982 | VANHULLE |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO Form 1503 03.82